(19) Europäisches Patentamt
European Patent Office
Office européen des brevets

(11) **EP 3 037 899 B1**

(12) **FASCICULE DE BREVET EUROPEEN**

(45) Date de publication et mention
de la délivrance du brevet:
**13.09.2017 Bulletin 2017/37**

(51) Int Cl.:
***G04C 3/14*** *(2006.01)* ***G01D 5/241*** *(2006.01)*

(21) Numéro de dépôt: **15202349.5**

(22) Date de dépôt: **23.12.2015**

(54) **PIECE D'HORLOGERIE COMPORTANT UN MOBILE DE POSITION ANGULAIRE DETERMINABLE**

UHR, DIE EINE TRIEBFEDER MIT EINSTELLBARER WINKELPOSITION UMFASST

TIMEPIECE COMPRISING A WHEEL WITH A DETERMINABLE ANGULAR POSITION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.12.2014 EP 14200171**

(43) Date de publication de la demande:
**29.06.2016 Bulletin 2016/26**

(73) Titulaire: **ETA SA Manufacture Horlogère Suisse
2540 Grenchen (CH)**

(72) Inventeurs:
• **Largorgette, Pascal
2502 Bienne (CH)**
• **Tardivon, Matthieu
1020 Renens (CH)**
• **Rufener, René
2504 Bienne (CH)**

(74) Mandataire: **Goulette, Ludivine et al
ICB
Ingénieurs Conseils en Brevets SA
Faubourg de l'Hôpital 3
2001 Neuchâtel (CH)**

(56) Documents cités:
**JP-A- 2004 163 128      JP-A- 2004 233 132
US-A- 5 598 153           US-B1- 6 307 814**

• **VEZ P ET AL: "Systeme de detection et de
synchronisation des aiguilles d'une montre",
ACTES DU CONGRES EUROPEEN DE
CHRONOMETRIE, SOCIETE SUIISE DE
CHRONOMETRIE, NEUCHATEL, CH, 26
septembre 2007 (2007-09-26), pages 107-109,
XP001551332, ISSN: 1023-2699**

EP 3 037 899 B1

**Description**

Domaine de l'invention

L'invention se rapporte au domaine technique des pièces d'horlogerie comprenant un mouvement horloger pourvu d'un affichage analogique et d'au moins un mobile solidaire en rotation d'un indicateur rotatif de cet affichage analogique.

Arrière-plan de l'invention

Pour déterminer la position angulaire d'un tel mobile, il est connu de la demande EP 0 952 426 de doter celui-ci d'une couche de surface faite d'un matériau particulier, ainsi que d'une ouverture traversante située dans une région intermédiaire entre l'axe de rotation du mobile et sa circonférence. Un capteur de proximité, statique par rapport au mobile, est positionné directement au-dessus ou en-dessous de l'ouverture lorsque le mobile est dans une position de référence. Ce capteur est apte à détecter le matériau particulier et à fournir un signal de mesure dépendant des variations de proximité dudit matériau. Ainsi, le signal de mesure présente une forme particulière lorsque l'ouverture passe au-dessus du capteur, par exemple un pic.

Pour déterminer une position angulaire dans laquelle se trouve le mobile, il est proposé de lui faire effectuer une rotation pas à pas complète par l'intermédiaire d'un moteur pas à pas, tout en relevant le signal de mesure. Le pic précédemment évoqué indique alors le passage du mobile par sa position de référence. Une fois la position de référence identifiée sur le graphique représentant le signal de mesure, il est aisé de déduire la position angulaire du mobile correspondant à autre point du graphique, en particulier la position angulaire d'origine du mobile, c'est-à-dire sa position avant qu'il n'entame la rotation.

Le document EP 0 952 426 propose d'utiliser un capteur inductif ou un capteur capacitif, en précisant toutefois qu'un capteur capacitif est plus sensible à l'environnement et aux perturbations engendrées par les tolérances de fabrication et de montage qu'un capteur inductif. Un capteur capacitif est notamment particulièrement influencé par l'ébat de hauteur, dans la direction de l'axe de rotation du mobile, entre le mobile et le capteur. Plus cet ébat est important, plus le pic est large : la précision de la détection de la position angulaire de référence est donc directement impactée par l'ébat de hauteur.

Le document JP2004 163128 A décrit une pièce d'horlogerie comprenant :

- un mouvement horloger pourvu d'un affichage analogique et d'au moins un mobile solidaire en rotation d'un indicateur rotatif dudit affichage analogique, ledit mobile comprenant un plateau électriquement conducteur s'étendant sensiblement orthogonalement à l'axe de rotation du mobile, le plateau étant lui même percé d'une ouverture;
- un dispositif de détection d'une position angulaire de référence du mobile, et donc, par conséquent, aussi de l'ouverture, le dispositif de détection étant du type capacitif et comprenant au moins un jeu d'électrodes comportant une première électrode, une deuxième électrode, et une électrode commune planes agencées dans un plan parallèle au mobile, l'électrode commune étant disposée le long de portions de la première électrode et de la deuxième électrode.

Dans la pièce d'horlogerie décrite dans JP2004 163128 A, lors de la rotation du mobile, l'ouverture se retrouve au moins:

- dans une première position, dans laquelle elle se superpose à la première électrode;
- dans une deuxième position, dans laquelle elle se superpose à la deuxième électrode; et
- dans une troisième position, dans laquelle elle se superpose aux deux électrodes.

Résumé de l'invention

Le but de la présente invention est de pallier l'inconvénient cité précédemment en proposant une solution de détermination de la position angulaire d'un mobile par un capteur capacitif, dont la précision n'est pas impactée par les variations d'ébats de hauteur entre le mobile et le capteur.

A cet effet, l'invention se rapporte à une pièce d'horlogerie telle que définie dans la revendication indépendante 1. La première électrode et l'électrode commune forment un premier condensateur électrique de capacité dite C1, tandis que la deuxième électrode et l'électrode commune forment un deuxième condensateur électrique de capacité dite C2. En utilisant un moteur pas à pas permettant de faire subir au mobile une rotation complète pas à pas, ainsi qu'un circuit de mesure permettant de générer un signal de mesure représentant $\frac{C1-C2}{C1+C2}$ en fonction du nombre de pas, on obtient une courbe présentant un maximum et un minimum. Le minimum est observé lorsque l'ouverture est dans la première position de déséquilibre ; le maximum est observé lorsque l'ouverture est dans la deuxième position de déséquilibre ; la courbe est de valeur nulle lorsque l'ouverture est dans la position d'équilibre.

Etant donné que le maximum et le minimum sont caractéristiques de positons angulaires spécifiques du mobile, lorsque le maximum et le minimum ont été identifiés sur le graphique représentant le signal de mesure, il est possible de déduire la position angulaire du mobile correspondant à autre point du graphique. Il est notamment possible d'en déduire la position angulaire initiale du mobile, c'est-à-dire sa position avant qu'il n'entame la rotation, ce qui est la position recherchée.

L'utilisation d'une mesure différentielle de capacités, plutôt qu'une mesure simple d'une capacité comme c'est le cas de l'art antérieur, permet de rendre la forme de la courbe indépendante de l'ébat entre le mobile et les électrodes. Ainsi, même lorsque l'ébat est important, le maximum et le minimum sont précisément identifiables sur la courbe. De plus, identifier deux positions caractéristiques du mobile sur la courbe, plutôt qu'une seule comme c'est le cas de l'art antérieur, rend la détermination de la position angulaire du mobile plus fiable.

On note par ailleurs qu'on appelle électrode plane une pièce conductrice s'étendant significativement selon au moins deux directions dans un plan, en opposition aux électrodes en bâtons.

Par ailleurs, le plateau du mobile peut comprendre plus d'une ouverture, et le dispositif de détection peut comprendre plus d'un jeu d'électrodes du type précité. Dans ce cas, chaque ouverture est agencée de sorte à être en regard de la première et de la deuxième électrode d'un jeu dans une position spécifique du mobile.

En outre, la pièce d'horlogerie peut comprendre une ou plusieurs des caractéristiques ci-dessous, selon toutes les combinaisons techniquement possibles.

Dans un mode de réalisation non limitatif, les électrodes présentent toutes trois une aire sensiblement identique. Cette configuration est à l'origine d'un déséquilibre important entre la capacité C1 et la capacité C2, et par conséquent d'une amplitude en norme importante du maximum et du minimum de la courbe. Par ailleurs, on note que dans certaines configurations des électrodes, la courbe présente un décrochement entre le pic correspondant au maximum et le creux correspondant au minimum. On entend par décrochement une section de pente plus faible que de part et d'autre de la section. La configuration qui vient d'être évoquée permet de minimiser la longueur de ce décrochement.

Dans un mode de réalisation non limitatif, l'ouverture est au moins partiellement au-dessus ou au-dessous de l'électrode commune dans la première position de déséquilibre, la position d'équilibre et la deuxième position de déséquilibre. Cette configuration permet l'obtention d'un pic et d'un creux particulièrement marqués.

Dans un mode de réalisation non limitatif, les trois électrodes sont en intégralité au-dessus ou au-dessous de l'ouverture dans la deuxième position. L'ouverture du mobile est alors éventuellement plus petite que l'ensemble des électrodes. Cette configuration permet d'éliminer un éventuel décrochement entre le pic et le creux de la courbe.

Dans un mode de réalisation non limitatif, l'électrode commune comporte deux demi-électrodes planes électriquement connectées l'une à l'autre, les demi-électrodes étant disposées de part et d'autre de l'ensemble constitué par la première et la deuxième électrode.

Dans un mode de réalisation non limitatif, l'électrode commune comporte deux demi-électrodes planes électriquement connectées l'une à l'autre, les demi-électrodes étant disposées entre la première et la deuxième électrode.

Dans un mode de réalisation non limitatif, la première électrode et la deuxième électrode sont côte à côte, et l'électrode commune s'étend sensiblement en forme de portion annulaire le long de la première et la deuxième électrode. Cette configuration permet d'utiliser une première et une deuxième électrode de surfaces importantes, par exemple une première et une deuxième électrode dont la surface totale est sensiblement celle de l'ouverture. Des surfaces importantes de la première et la deuxième électrode sont à l'origine d'une amplitude importante en norme du maximum et du minimum sur la courbe.

L'invention concerne également un procédé de détermination d'une position angulaire d'un mobile d'un mouvement horloger d'une pièce d'horlogerie telle qu'évoquée dans les paragraphes précédents, comprenant :

- une rotation pas à pas dudit mobile, par exemple au moyen d'un moteur pas à pas

- simultanément à la rotation, une mesure de $\frac{C1-C2}{C1+C2}$ en fonction des pas de la rotation, où C1 est une capacité électrique d'un condensateur formé par la première électrode et l'électrode commune, et C2 est une capacité électrique d'un condensateur formé par la deuxième électrode et l'électrode commune

- une détection d'un maximum et d'un minimum sur une courbe représentative la mesure
- une détermination de la position angulaire du mobile, au moyen du maximum et du minimum détectés.

Description sommaire des dessins

D'autres particularités et avantages ressortiront clairement de la description qui en est faite ci-après, à titre indicatif et nullement limitatif, en référence aux dessins annexés, dans lesquels :

- la figure 1 représente un dispositif de détection d'une position angulaire d'un mobile rotatif d'un mouvement horloger d'une pièce d'horlogerie, superposé au-dessus dudit mobile, selon un premier mode de réalisation de l'invention ;
- la figure 2a représente le dispositif de détection de la figure 1, ainsi que le mobile rotatif dans une première position angulaire occupée lors d'une rotation complète dudit mobile à partir de la position angulaire initiale ;
- la figure 2b représente une courbe de mesure réalisée au fur et à mesure de la rotation du mobile, dans un état correspondant à la position du mobile sur la figure 2a ;
- la figure 3a représente le dispositif de détection de la figure 1, ainsi que le mobile rotatif dans une deuxième position angulaire, dite première position de déséquilibre, occupée lors d'une rotation complète dudit mobile à partir de la position angulaire initiale ;

- la figure 3b représente la courbe de mesure dans un état correspondant à la position du mobile sur la figure 3a ;

- la figure 4a représente le dispositif de détection de la figure 1, ainsi que le mobile rotatif dans une troisième position angulaire, dite position d'équilibre, occupée lors d'une rotation complète dudit mobile à partir de la position angulaire initiale ;

- la figure 4b représente la courbe de mesure dans un état correspondant à la position du mobile sur la figure 4a ;

- la figure 5a représente le dispositif de détection de la figure 1, ainsi que le mobile rotatif dans une quatrième position angulaire, dite deuxième position d'équilibre, occupée lors d'une rotation complète dudit mobile à partir de la position angulaire initiale ;

- la figure 5b représente la courbe de mesure dans un état correspondant à la position du mobile sur la figure 5a ;

- la figure 6a représente le dispositif de détection de la figure 1, ainsi que le mobile rotatif dans une cinquième position angulaire occupée lors d'une rotation complète dudit mobile à partir de la position angulaire initiale ;

- la figure 6b représente la courbe de mesure dans un état correspondant à la position du mobile sur la figure 6a ;

- la figure 7a représente le dispositif de détection de la figure 1 ainsi que le mobile rotatif de retour dans la position angulaire d'origine après d'une rotation complète du mobile ;

- la figure 7b représente la courbe de mesure dans un état correspondant à la position du mobile sur la figure 7a ;

- la figure 8 représente un tel dispositif selon un deuxième mode de réalisation de l'invention ;

- la figure 9 représente un tel dispositif selon un troisième mode de réalisation de l'invention ;

- la figure 10 représente un tel dispositif selon un quatrième mode de réalisation de l'invention ;

- la figure 11 représente un tel dispositif selon un cinquième mode de réalisation de l'invention.

<u>Description détaillée des modes de réalisation préférés</u>

L'invention concerne une pièce d'horlogerie comprenant un mouvement horloger. Le mouvement horloger comporte un mobile MB en forme de disque, qui comprend en outre un arbre définissant un axe géométrique de rotation. Le mouvement horloger est associé à un affichage analogique comprenant un indicateur rotatif monté fixement sur l'arbre, non représenté. L'indicateur peut servir à indiquer l'heure, la minute, la seconde, ou toute autre information prévue pour un affichage analogique.

Le mobile MB comporte un plateau PT électriquement conducteur, s'étendant sensiblement orthogonalement à l'axe de rotation du mobile MB. Ledit plateau PT est percé d'une ouverture traversante OV en forme de portion annulaire, placée dans une région intermédiaire entre sa périphérie et un trou central prévu pour le passage de l'arbre. L'ouverture traversante OV s'étend par exemple sur 120 degrés.

En vis-à-vis du mobile MB, au-dessus ou au-dessous du mobile MB, est positionnée une plaque PA, par exemple en forme de demi-disque. La plaque PA s'étend sensiblement parallèlement au plateau PL du mobile MB et orthogonalement à l'axe de rotation du mobile MB. Avantageusement, la plaque PA est une plaque de circuit imprimé (Printed Circuit Board en terminologie anglo-saxonne, PCB) sur laquelle trois électrodes planes sont imprimées. Contrairement au mobile, la plaque PA est fixe : le mobile est donc apte à tourner par rapport à la plaque PA.

La plaque PA comprend un jeu d'électrodes. Le jeu d'électrodes comprend trois électrodes planes, appelées première électrode E1, deuxième électrode E2, et électrode commune Em. Les trois électrodes E1, E2, Em ont la forme de portions annulaires. L'électrode commune Em est disposée le long de portions de la première électrode E1 et de la deuxième électrode E2, de sorte à former avec la première électrode E1 un premier condensateur électrique de capacité dite C1, et avec la deuxième électrode E2 un deuxième condensateur électrique de capacité dite C2. Du fait de la présence de l'ouverture OV dans le plateau PT, la valeur des capacités C1, C2 dépend de la position angulaire du mobile MB par rapport aux électrodes E1, E2, Em. En particulier, la capacité C1, respectivement C2, est maximale lorsque l'ouverture OV se trouve au-dessus de la première électrode E1 et de l'électrode commune Em, respectivement au-dessus de la deuxième électrode E2 et de l'électrode commune Em, car le transfert de charges électriques d'une électrode à l'autre n'est plus facilité par la présence du matériau électriquement conducteur du plateau PT.

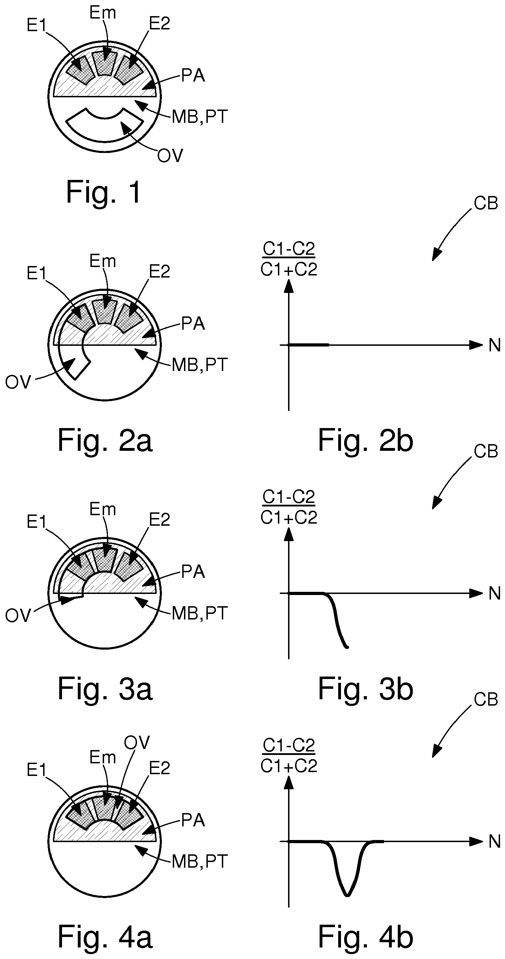

Une première configuration de ces électrodes E1, E2, Em sur la plaque PA est montrée à la figure 1. Dans cette configuration, les trois électrodes E1, E2, Em sont de surfaces sensiblement identiques, et l'électrode commune Em est placée entre la première électrode E1 et la deuxième électrode E2. De plus, la surface totale des électrodes E1, E2, Em est sensiblement de l'ordre de la surface de l'ouverture OV. Dans le mode de réalisation illustré à la figure 1, l'ouverture OV s'étend sur 120 degrés et chaque électrode s'étend sur 120/3*0,98=38 degrés (naturellement, ces caractéristiques angulaires ne sont pas limitatives). Ainsi, il existe une position angulaire du mobile MB par rapport à la plaque PA (celle montrée sur la figure 4a) dans laquelle les 3 électrodes E1, E2, Em sont intégralement en vis-à-vis de l'ouverture OV, et l'ouverture OV est également intégralement en vis-à-vis des électrodes E1, E2, Em.

Pour déterminer une position angulaire initiale du mobile MB, qui est celle de la figure 1 dans l'exemple non limitatif présenté plus loin, il est proposé de faire effectuer une rotation complète pas-à-pas au mobile MB autour de son axe de rotation. Cette rotation est réalisée au moyen d'un moteur pas-à-pas, non représenté. Le moteur pas-à-pas est par exemple un moteur bipolaire du type « moteur Lavet ». La transmission du moteur au mobile (non représentée) est de préférence constituée par un rouage réducteur. Un circuit électronique de mesure, comprenant par exemple un microcontrôleur, est agencé pour mesurer la valeur de $\frac{C1-C2}{C1+C2}$ en fonction du nombre de pas imposé au mobile MB, et générer une courbe de mesure CB.

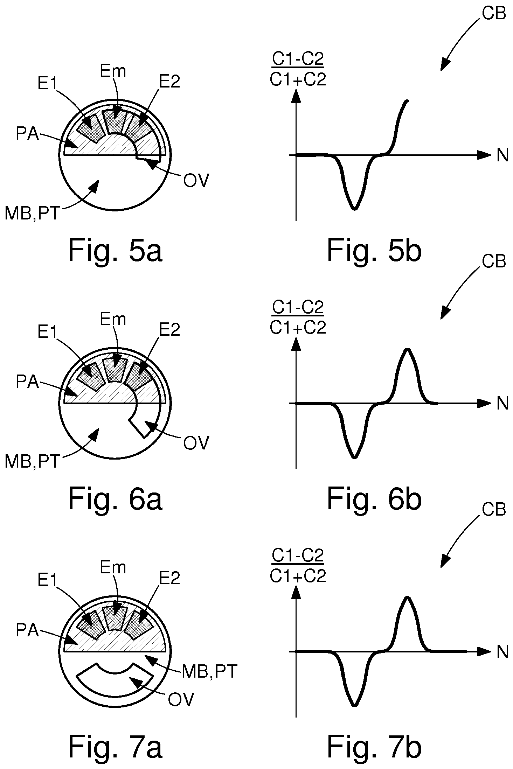

Les figures 2a, 3a, 4a, 5a, 6a et 7a montrent des positions angulaires successives du mobile MB par rapport au plateau PT lors d'une rotation complète dudit mobile MB à partir de la position de la figure 1. Dans la position de la figure 2a, la première électrode E1 seulement est en vis-à-vis de l'ouverture OV du mobile MB. Dans la position de la figure 3a, la première électrode E1 et l'électrode commune Em se trouvent en vis-à-vis de l'ouverture OV. Dans la position de la figure 4a, les trois électrodes E1, E2, Em sont toutes trois en vis-à-vis de l'ouverture. Dans la position de la figure 5a, l'électrode commune Em et la deuxième électrode E2 sont en vis-à-vis de l'ouverture. Dans la position de la figure 6a, seule la deuxième électrode E2 est en vis-à-vis de l'ouverture OV. Enfin, dans la position de la figure 7a, le mobile MB est de retour dans sa position initiale : aucune des trois électrodes E1, E2, Em n'est en vis-à-vis de l'ouverture OV.

Les figures 2b, 3b, 4b, 5b, 6b et 7b illustrent la courbe de mesure CB représentant $\frac{C1-C2}{C1+C2}$ en fonction d'un nombre de pas N imposé au mobile MB, à des moments correspondant aux positions qu'occupe le mobile MB aux figures 2a, 3a, 4a, 5a, 6a et 7a.

Comme le montre la figure 2b, la courbe de mesure CB est de valeur nulle depuis la position initiale du mobile MB jusqu'à la position de la figure 2a. Puis, comme le montre la figure 3b, la valeur de $\frac{C1-C2}{C1+C2}$ diminue entre la position de la figure 2a et la position de la figure 3a. La courbe CB atteint notamment une valeur minimale lorsque l'électrode E1 et l'électrode commune Em sont toutes deux, et toutes deux seulement, en vis-à-vis de l'ouverture OV.

Comme le montre la figure 4b, les valeurs prises par la courbe CB augmentent jusqu'à revenir à une valeur nulle entre la position de la figure 3a et la position de la figure 4a. Puis, comme le montre la figure 5b, la valeur de $\frac{C1-C2}{C1+C2}$ diminue entre la position de la figure 4a et la position de la figure 5a. La courbe CB atteint notamment une valeur maximale lorsque l'électrode E2 et l'électrode commune Em sont toutes deux, et toutes deux seulement, en vis-à-vis de l'ouverture OV.

Puis, comme le montre la figure 6b, entre la position de la figure 5a et la position de la figure 6a, les valeurs prises par la courbe CB diminuent jusqu'à revenir à une valeur nulle. Enfin, jusqu'au retour du mobile MB dans sa position angulaire initiale, la courbe CB est de valeur nulle.

Par exploitation de la courbe CB, on calcule alors deux positions caractéristiques du mobile MB. Dans la première, qui correspond à la position de la figure 3a, la courbe CB présente un minimum ; dans la seconde, qui correspond à la position de la figure 5a, la courbe CB présente un maximum. Etant donné que les nombres de pas pour atteindre la position correspondant au minimum et la position correspondant au maximum sont déterminables à partir de la courbe CB, il est aisé d'en déduire la position initiale du mobile MB.

On note que des configurations des électrodes E1, E2, Em sur la plaque PA et/ou de l'ouverture OV sur le plateau PT, autres que celles présentées en référence à la figure 1, sont possibles.

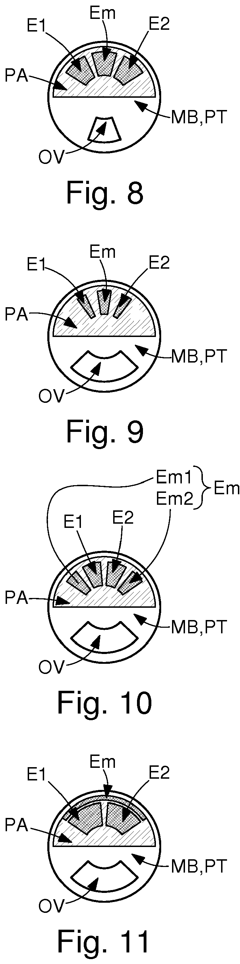

Dans la configuration de la figure 8, les électrodes E1, E2, Em sont semblables à celles de la figure 1, mais l'ouverture OV s'étend sur 80 degrés seulement (naturellement, cette ouverture angulaire n'est pas limitative). Il n'y a donc pas de position angulaire du mobile MB dans laquelle les trois électrodes E1, E2, Em sont intégralement en vis-à-vis de l'ouverture OV. Cette configuration permet d'éviter le décrochement, observé sur la figure 7b, entre le pic correspondant au maximum et le creux correspondant au minimum.

Dans la configuration de la figure 9, les trois électrodes E1, E2, Em ne sont pas de surfaces identiques : la première électrode E1 et la deuxième électrode E2 sont de même surfaces mais l'électrode commune Em est de surface supérieure. Dans le mode de réalisation illustré à la figure 9, la première électrode E1 et la deuxième électrode E2 s'étendent sur 10 degrés, tandis que l'électrode commune Em s'étend sur 18 degrés (naturellement, ces caractéristiques angulaires ne sont pas limitatives). L'ouverture OV s'étend toutefois sur 120 degrés : la surface de l'ouverture OV est donc considérablement plus grande que la somme des surfaces des électrodes E1, E2, Em.

Dans la configuration de la figure 10, la première électrode E1 et la deuxième électrode E2 sont côtes à côtes, et l'électrode commune Em est constituée de deux demi-électrodes électriquement connectées (la connexion n'est pas représentée). Les demi-électrodes sont placées de part et d'autre de l'ensemble constitué par la première électrode E1 et la deuxième électrode E2. On note qu'alternativement, les deux demi-électrodes pourraient être placées entre la première électrode E1 et la deuxième électrode E2.

Dans la configuration de la figure 11, la première électrode E1 et la deuxième électrode E2 sont côtes à côtes, et l'électrode commune Em est disposée le long de la portion externe de ces électrodes E1, E2. De plus, la surface totale de la première électrode E1 et de la deuxième électrode E2 est sensiblement égale à la surface de l'ouverture OV. Il n'y a donc pas de position dans laquelle l'électrode commune Em est en vis-à-vis de l'ouverture OV. Cette configuration permet d'augmenter les surfaces de la première électrode E1 et de la deuxième électrode E2, et ainsi l'amplitude du pic et du creux de la courbe de mesure CB. De plus, cette configuration permet d'éviter le décrochement observé sur la figure 7b, entre le pic correspondant au maximum et le creux correspondant au minimum.

Bien entendu, la présente invention ne se limite pas aux exemples illustrés mais est susceptible de diverses variantes et modifications qui apparaîtront à l'homme de l'art. Par exemple, le mobile MB pourrait être percé de K ouvertures OV, K≥2, et la plaque PA pourrait comporter K jeux de 3 électrodes telles que celles présentées précédemment. Cela permettrait l'obtention d'amplitudes plus grandes (en norme) du pic et du creux de la courbe de mesure.

**Revendications**

1. Pièce d'horlogerie comprenant :

    - un mouvement horloger pourvu d'un affichage analogique et d'au moins un mobile (MB) solidaire en rotation d'un indicateur rotatif dudit affichage analogique, ledit mobile (MB) comprenant un plateau (PT) électriquement conducteur s'étendant sensiblement orthogonalement à l'axe de rotation du mobile (MB) et percé d'au moins une ouverture (OV),
    - un dispositif de détection d'une position angulaire de référence de l'ouverture (OV), le dispositif de détection étant de type capacitif et comprenant au moins un jeu d'électrodes comportant une première électrode (E1), une deuxième électrode (E2), et une électrode commune (Em) planes agencées dans un plan parallèle au mobile (MB), l'électrode commune (Em) étant disposée le long de portions de la première électrode (E1) et de la deuxième électrode (E2), le dispositif de détection étant agencé pour détecter la différence entre une capacité électrique C1 d'un condensateur formé par la première électrode (E1) et l'électrode commune (Em), et une capacité électrique C2 d'un condensateur formé par la deuxième électrode (E2) et l'électrode commune (Em)

    l'ouverture (OV) étant au moins partiellement au-dessus ou au-dessous :

    - de la première électrode (E1) dans une position dite première position de déséquilibre
    - de la première électrode (E1) et de la deuxième électrode (E2) dans une position dite d'équilibre
    - de la deuxième électrode (E2) dans une position dite deuxième position de déséquilibre.

2. Pièce d'horlogerie selon la revendication 1, les électrodes (E1, E2, Em) présentant toutes trois une aire sensiblement identique.

3. Pièce d'horlogerie selon l'une des revendications précédentes, l'ouverture (OV) étant au moins partiellement au-dessus ou au-dessous de l'électrode commune (Em) dans la première position de déséquilibre, la position d'équilibre et la deuxième position de déséquilibre.

4. Pièce d'horlogerie selon la revendication précédente, les trois électrodes (E1, E2, Em) étant en intégralité au-dessus ou au-dessous de l'ouverture (OV) dans la position d'équilibre.

5. Pièce d'horlogerie selon l'une des revendications précédentes, l'électrode commune (Em) comportant deux demi-électrodes (Em1, Em2) planes électriquement connectées l'une à l'autre, les demi-électrodes (Em1, Em2) étant disposées de part et d'autre de l'ensemble constitué par la première électrode (E1) et la deuxième électrode (E2).

6. Pièce d'horlogerie selon l'une des revendications 1 à 4, l'électrode commune (Em) comportant deux demi-électrodes (Em1, Em2) planes électriquement connectées l'une à l'autre, les demi-électrodes (Em1, Em2) étant disposées entre la première électrode (E1) et la deuxième électrode (E2).

7. Pièce d'horlogerie selon l'une des revendications 1 à 2, la première électrode (E1) et la deuxième électrode (E2) étant placés côte à côté, et l'électrode commune (Em) s'étendant sensiblement en forme de portion annulaire le long de la première électrode (E1) et la deuxième électrode (E2).

8. Procédé de détermination d'une position angulaire d'un mobile (MB) d'un mouvement horloger d'une pièce d'horlogerie selon l'une des revendications précédentes, comprenant :

    - une rotation pas-à-pas dudit mobile (MB)
    - simultanément à la rotation, une mesure de $\frac{C1-C2}{C1+C2}$ en fonction des pas de la rotation, où C1 est une capacité électrique d'un condensateur formé par la première électrode (E1) et l'électrode commune (Em), et C2 est une capacité électrique d'un condensateur formé par la deuxième électrode (E2) et l'électrode commune (Em)

- une détection d'un maximum et d'un minimum sur une courbe (CB) représentative la mesure
- une détermination de la position angulaire du mobile (MB), au moyen du maximum et du minimum détectés.

## Patentansprüche

1. Zeitmessgerät, umfassend:

   - ein Uhrwerk, versehen mit einer analogen Anzeige und mit mindestens einem Drehteil (MB), das mit einem Drehanzeiger der analogen Anzeige drehfest verbunden ist, wobei das Drehteil (MB) eine elektrisch leitende Platte (PT) aufweist, die sich im Wesentlichen senkrecht zu der Drehachse des Drehteils (MB) erstreckt und die von mindestens einer Öffnung (OV) durchbrochen ist,
   - eine Vorrichtung zum Detektieren einer Referenzwinkelposition der Öffnung (OV), wobei die Detektionsvorrichtung vom kapazitiven Typ ist und mindestens einen Satz Elektroden aufweist, der eine erste Elektrode (E1), eine zweite Elektrode (E2) und eine gemeinsame Elektrode (Em) umfasst, die eben sind und in einer Ebene parallel zu dem Drehteil (MB) angeordnet sind, wobei die gemeinsame Elektrode (Em) entlang von Abschnitten der ersten Elektrode (E1) und der zweiten Elektrode (E2) angeordnet ist, und die Detektionsvorrichtung dafür ausgelegt ist, die Differenz zwischen einer elektrischen Kapazität C1 eines durch die erste Elektrode (E1) und die gemeinsame Elektrode (Em) gebildeten Kondensators und einer elektrischen Kapazität C2 eines durch die zweite Elektrode (E2) und die gemeinsame Elektrode (Em) gebildeten Kondensators zu detektieren,

   wobei sich die Öffnung (OV) zumindest teilweise oberhalb oder unterhalb von Folgendem befindet:

   - der ersten Elektrode (E1) in einer sogenannten ersten Ungleichgewichtsposition,
   - der ersten Elektrode (E1) und der zweiten Elektrode (E2) in einer Gleichgewichtsposition,
   - der zweiten Elektrode (E2) in einer sogenannten zweiten Ungleichgewichtsposition.

2. Zeitmessgerät nach Anspruch 1, wobei alle drei Elektroden (E1, E2, Em) einen im Wesentlichen übereinstimmenden Flächeninhalt haben.

3. Zeitmessgerät nach einem der vorhergehenden Ansprüche, wobei sich die Öffnung (OV) in der ersten Ungleichgewichtsposition, der Gleichgewichtsposition und der zweiten Ungleichgewichtsposition zumindest teilweise oberhalb oder unterhalb der gemeinsamen Elektrode (Em) befindet.

4. Zeitmessgerät nach dem vorhergehenden Anspruch, wobei sich die drei Elektroden (E1, E2, Em) in der Gleichgewichtsposition vollständig oberhalb oder unterhalb der Öffnung (OV) befinden.

5. Zeitmessgerät nach einem der vorhergehenden Ansprüche, wobei die gemeinsame Elektrode (Em) zwei Halbelektroden (Em1, Em2) umfasst, die eben sind und miteinander elektrisch verbunden sind, wobei die Halbelektroden (Em1, Em2) beiderseits der Baugruppe angeordnet sind, die durch die erste Elektrode (E1) und die zweite Elektrode (E2) gebildet ist.

6. Zeitmessgerät nach einem der Ansprüche 1 bis 4, wobei die gemeinsame Elektrode (Em) zwei Halbelektroden (Em1, Em2) umfasst, die eben und miteinander elektrisch verbunden sind, wobei die Halbelektroden (Em1, Em2) zwischen der ersten Elektrode (E1) und der zweiten Elektrode (E2) angeordnet sind.

7. Zeitmessgerät nach einem der Ansprüche 1 bis 2, wobei die erste Elektrode (E1) und die zweite Elektrode (E2) Seite an Seite angeordnet sind und sich die gemeinsame Elektrode (Em) im Wesentlichen in Form eines ringförmigen Abschnitts entlang der ersten Elektrode (E1) und der zweiten Elektrode (E2) erstreckt.

8. Verfahren zum Bestimmen einer Winkelposition eines Drehteils (MB) eines Uhrwerks eines Zeitmessgeräts nach einem der vorhergehenden Ansprüche, umfassend:

   - schrittweises Drehen des Drehteils (MB),
   - gleichzeitig zu der Drehung Messen von (C1 - C2)/(C1 + C2) als Funktion der Schritte der Drehung, wobei C1 eine elektrische Kapazität eines durch die erste Elektrode (E1) und die gemeinsame Elektrode (Em) gebildeten Kondensators ist, und C2 eine elektrische Kapazität eines durch die zweite Elektrode (E2) und die gemeinsame Elektrode (Em) gebildeten Kondensators ist,
   - Detektieren eines Maximums und eines Minimums auf einer Kurve (CB), die die Messung darstellt,
   - Bestimmen der Winkelposition des Drehteils (MB) mittels des detektierten Maximums und des detektierten Minimums.

**Claims**

1. Timepiece including:

   - a timepiece movement provided with an analogue display and with at least one wheel set (MB) rotating integrally with a rotary indicator of said analogue display, said wheel set (MB) including an electrically conductive plate (PT) extending substantially orthogonally to the axis of rotation of the wheel set (MB), and pierced with at least one aperture (OV),
   - a device for detection of a reference angular position of the aperture (OV), the detection device including at least one set of planar electrodes comprising a first electrode (E1), a second electrode (E2), and a common electrode (Em) arranged in a plane parallel to the wheel set (MB), the common electrode (Em) being arranged along portions of the first electrode (E1) and of the second electrode (E2), the detection device being arranged to detect the difference between an electrical capacitance C1 of a capacitor made by the first electrode (E1) and the common electrode (Em), and an electrical capacitance C2 of a capacitor made by the second electrode (E2) and the common electrode (Em).

   the aperture (OV) being at least partially above or below:

   - the first electrode (E1) in a position called the first position of disequilibrium
   - the first electrode (E1) and the second electrode (E2) in a position called the position of equilibrium
   - the second electrode (E2) in a position called the second position of disequilibrium.

2. Timepiece according to claim 1, wherein all three of the electrodes (E1, E2, Em) have a substantially identical area.

3. Timepiece according to any of the preceding claims, wherein the aperture (OV) is at least partially above or below the common electrode (Em) in the first position of disequilibrium, the position of equilibrium and the second position of disequilibrium.

4. Timepiece according to the preceding claim, wherein the three electrodes (E1, E2, Em) are completely above or below the aperture (OV) in the position of equilibrium.

5. Timepiece according to any of the preceding claims, wherein the common electrode (Em) includes two planar half electrodes (Em1, Em2) electrically connected to each other, the half electrodes (Em1, Em2) being arranged on either side of the assembly formed by the first electrode (E1) and the second electrode (E2).

6. Timepiece according to any of claims 1 to 4, wherein the common electrode (Em) includes two planar half electrodes (Em1, Em2) electrically connected to each other, the half electrodes (Em1, Em2) being arranged between the first electrode (E1) and the second electrode (E2).

7. Timepiece according to claim 1 or claim 2, wherein the first electrode (E1) and the second electrode (E2) are placed side-by-side, and the common electrode (Em) extends substantially in the shape of an annular portion along the first electrode (E1) and the second electrode (E2).

8. Method for determination of an angular position of a wheel set (MB) of a timepiece movement of a timepiece according to claim 1, including:

   - a stepwise rotation of said wheel set (MB)
   - simultaneously with the rotation, a measurement of $\dfrac{C1-C2}{C1+C2}$ as a function of the rotational steps, where C1 is an electrical capacitance of a capacitor formed by the first electrode (E1) and the common electrode (Em), and C2 is an electrical capacitance of a capacitor formed by the second electrode (E2) and the common electrode (Em)
   - detection of a maximum and of a minimum on a curve (CB) representing the measurement
   - determination of the angular position of the wheel set (MB), by means of the detected maximum and minimum.

Fig. 1

Fig. 2a

Fig. 2b

Fig. 3a

Fig. 3b

Fig. 4a

Fig. 4b

**Fig. 5a**

**Fig. 5b**

$$\frac{C1-C2}{C1+C2}$$

**Fig. 6a**

**Fig. 6b**

$$\frac{C1-C2}{C1+C2}$$

**Fig. 7a**

**Fig. 7b**

$$\frac{C1-C2}{C1+C2}$$

Fig. 8

Fig. 9

Fig. 10

Fig. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0952426 A

- JP 2004163128 A